# FASCICULE DE BREVET EUROPEEN

(11) **EP 3 884 526 B1**
(45) Date de publication et mention de la délivrance du brevet: **19.01.2022**
(21) Numéro de dépôt: 20842283.2
(22) Date de dépôt: 10.12.2020
(51) Int. Cl.: H01L 31/048, H02S 30/20

(54) **GÉNÉRATEUR SOLAIRE FLEXIBLE DE SATELLITE ET SON PROCÉDÉ DE FABRICATION**
FLEXIBLER SATELLITENSOLARGENERATOR UND DESSEN HERSTELLUNGSVERFAHREN
FLEXIBLE SATELLITE SOLAR GENERATOR AND ITS MANUFACTURING METHOD

(30) Priorité: 19.12.2019 FR 1914823
(43) Date de publication de la demande: 29.09.2021
(73) Titulaire: Airbus Defence and Space SAS, 31402 Toulouse Cedex 4 (FR)
(72) Inventeur: MHIBIK, Oumaima, 31402 Toulouse Cedex 4 (FR); VERGNET, Dominique, 31402 Toulouse Cedex 4 (FR)
(74) Mandataire: Plasseraud IP
(86) Numéro de dépôt international: PCT/FR2020/052373
(87) Numéro de publication internationale: WO 2021/123575

(56) Documents cités:
- CN-A- 109 067 346
- US-A1- 2009 301 544
- US-A1- 2013 008 483
- US-A1- 2017 093 326
- US-A1- 2018 020 536

## Description

### Domaine technique

La présente demande concerne un générateur solaire flexible de satellite et un satellite comprenant au moins un générateur solaire flexible. L'invention porte également sur un procédé de fabrication d'un module photovoltaïque.

### Technique antérieure

Dans une tendance générale de réduction des coûts des satellites, on cherche actuellement à développer des satellites très compacts, afin de pouvoir loger plusieurs satellites dans une même coiffe de lanceur et ainsi procéder à une mise en commun du lanceur pour lancer plusieurs satellites.

En particulier, les générateurs solaires d'un satellite sont des composants situés à l'extérieur du corps principal du satellite, et pour cette raison il existe un besoin fort de solutions de plus en plus compactes.

Dans cette perspective, des générateurs solaires flexibles, par exemple pliables ou enroulables, ont été proposés, comprenant un support flexible et des cellules photovoltaïques rapportées sur le support flexible.

Dans les solutions de l'art antérieur, les cellules photovoltaïques peuvent être connectées entre elles, et au satellite, par des harnais filaires, mais ces harnais filaires sont généralement encombrants car les fils utilisés doivent pouvoir faire transiter une puissance élevée vers le satellite, qui peut atteindre de l'ordre de 15kW.

Dans d'autres solutions, comme par exemple dans les documents US 4,043,834 US 10,014,817 et US 2009/301544 les harnais filaires sont remplacés par des pistes électriquement conductrices agencées sur ou dans les supports flexibles.

Pour autant, ces solutions de l'art antérieur ne sont pas sans inconvénients. D'une part, l'utilisation de pistes électriquement conductrices sur une surface du support flexible expose ces pistes à de l'oxygène atomique présent dans l'espace ou des ions générés par la production électrique des cellules photovoltaïques, ce qui provoque de l'érosion de ces pistes, et empêche donc la production d'une tension électrique élevée. Les pistes sont également exposées aux radiations électromagnétiques présentes dans l'espace et pouvant engendrer des décharges électrostatiques. Les cellules solaires sont quant à elles protégées de ces radiations par des verres de protection recouvrant chaque cellule.

Et même quand les pistes sont noyées dans le support flexible, ce qui confère une protection aux pistes, notamment contre l'érosion, la connexion entre les pistes n'est pas protégée.

De plus, ces solutions présentent un inconvénient supplémentaire de ne pas être modulaires, puisque, les pistes électriques étant réalisées dans le support flexible sur lequel sont montées les cellules photovoltaïques, il n'est pas possible d'ajuster facilement la conception du générateur solaire, par exemple pour moduler la puissance nominale pouvant être produite en fonction des besoins du satellite sur lequel le générateur solaire doit être monté.

### Résumé

L'invention vient améliorer la situation.

En particulier, un but de l'invention est de proposer un générateur solaire de satellite plus fiable car présentant une meilleure protection contre les radiations électromagnétiques présentes dans l'espace, et contre l'oxygène et les ions pouvant également être présents dans l'espace.

Un autre but de l'invention est de proposer un générateur solaire dont la conception est plus facilement ajustable aux besoins du satellite sur lequel le générateur doit être monté, et qui soit plus simple et moins coûteux à produire.

Il est ainsi proposé un générateur solaire de satellite selon la revendication 1. Dans un mode de réalisation, le support électriquement isolant de chaque module est flexible.

Dans un mode de réalisation, chaque module photovoltaïque comprend en outre une couche de matériau adhésif s'étendant entre les cellules photovoltaïques et le support, et une couche de matériau adhésif s'étendant entre la couche de protection et les cellules photovoltaïques.

Dans un mode de réalisation, les pistes électriquement conductrices de chaque module sont configurées pour établir une connexion série entre les chaînes de cellules.

Dans un mode de réalisation, le support flexible électriquement isolant du générateur solaire est pliable selon une pluralité de lignes de pliure parallèles, chaque module étant rapporté sur le support flexible entre deux lignes de pliure.

Dans un mode de réalisation, chaque module est rapporté sur le support flexible du générateur solaire de sorte que chaque chaine de cellules photovoltaïques s'étende parallèlement aux lignes de pliure.

Dans un mode de réalisation, le support flexible présente entre deux extrémités opposées une dimension principale s'étendant selon une direction orthogonale aux lignes de pliures,
le générateur solaire comprend en outre une première et une deuxième plaques de déploiement respectivement reliées aux extrémités opposées du support flexible, et un organe de déploiement adapté pour sélectivement rapprocher ou écarter les deux plaques de déploiement,
le générateur solaire étant adapté pour prendre une configuration repliée dans laquelle le support flexible est plié selon les lignes de pliure entre les deux plaques de déploiement, et une configuration déployée dans laquelle le support flexible s'étend de façon sensiblement plane entre les deux plaques de déploiement, lesdites plaques étant écartées l'une de l'autre,
et le dispositif de connexion est intégrée à l'une des plaques de déploiement.

Dans un mode de réalisation, le générateur solaire comprend un circuit imprimé comprenant le support flexible et une pluralité de pistes électriquement conductrices agencées sur ladite face du support flexible ou dans le support flexible.

Dans un mode de réalisation, au moins deux des pistes électriquement conductrices comprennent une première extrémité adaptée pour être raccordée au dispositif de connexion, une deuxième extrémité connectée à une chaîne de cellules, et une portion intermédiaire s'étendant entre les extrémités, l'ensemble des portions intermédiaires des pistes s'étendant parallèlement suivant la dimension principale du générateur solaire.

Dans un mode de réalisation, le générateur solaire comprend en outre une cale rapportée sur le support flexible de manière adjacente à chaque module photovoltaïque, la cale s'étendant en saillie par rapport au support flexible à une hauteur par rapport audit support flexibles supérieure à la hauteur d'un module photovoltaïque.

La présente a également pour objet un satellite comprenant au moins un générateur solaire selon la description qui précède.

La présente porte également sur un procédé de fabrication d'un générateur solaire de satellite selon la revendication 11.

Dans un mode de réalisation du procédé, l'étape de connexion est mise en œuvre par soudure électrique ou ultrasonore

Le générateur solaire selon la présente divulgation présente une protection accrue à la fois des cellules, des pistes conductrices du circuit imprimé, et des connexions entre les pistes et les cellules photovoltaïques, grâce à l'utilisation d'une couche de protection commune qui recouvre les pistes et les cellules, et qui permet également de supprimer la protection individuelle des cellules. Ceci permet en outre d'augmenter la tension nominale de fonctionnement du module, tout en allégeant la structure.

L'utilisation d'une couche de protection commune permet aussi de rigidifier le module en rigidifiant notamment les interstices entre les cellules.

De plus, le module proposé peut être monté facilement sur un support flexible pour former un générateur solaire flexible, dont la conception peut être ajustée en fonction du nombre de modules montés sur le support.

Dans un mode de réalisation, le support flexible porte également des pistes conductrices qui peuvent être connectées aux chaînes de cellules photovoltaïques des modules, afin de connecter ces chaînes en parallèle. De ce fait, le support flexible constitue donc à la fois un support mécanique et contribue à la connexion électrique entre les chaînes de cellules d'une part, et le satellite d'autre part. Il suffit alors de rapporter les modules sur le support flexible et de connecter les chaînes aux pistes électriquement conductrices du support flexible pour obtenir un générateur solaire pouvant être connecté au satellite. Ceci permet de simplifier le procédé de fabrication du générateur solaire et de réduire son coût.

### Brève description des dessins

D'autres caractéristiques, détails et avantages apparaîtront à la lecture de la description détaillée ci-après, et à l'analyse des dessins annexés, sur lesquels :
**Fig. 1a**

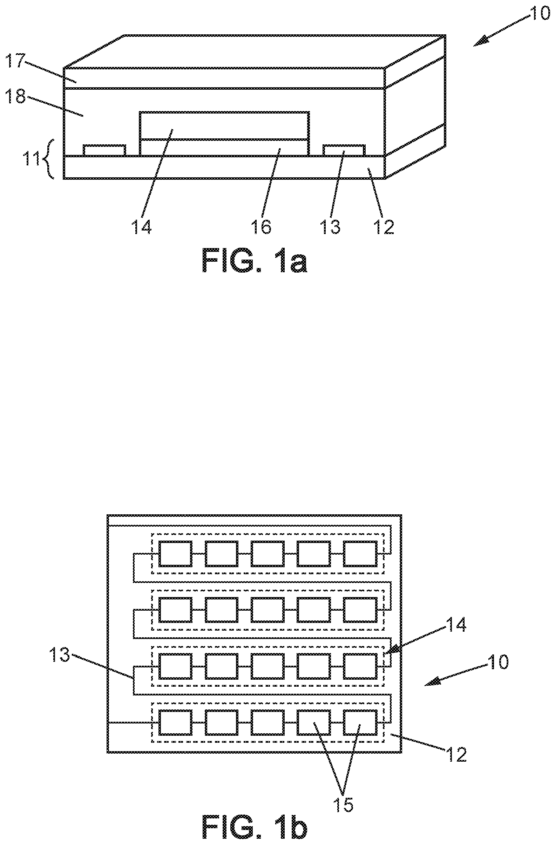

   [Fig. 1a] représente schématiquement une vue en coupe d'un module selon un mode de réalisation.
**Fig. 1b**
   [Fig. 1b] représente schématiquement une vue de dessus d'un module selon un mode de réalisation.
**Fig. 2a**

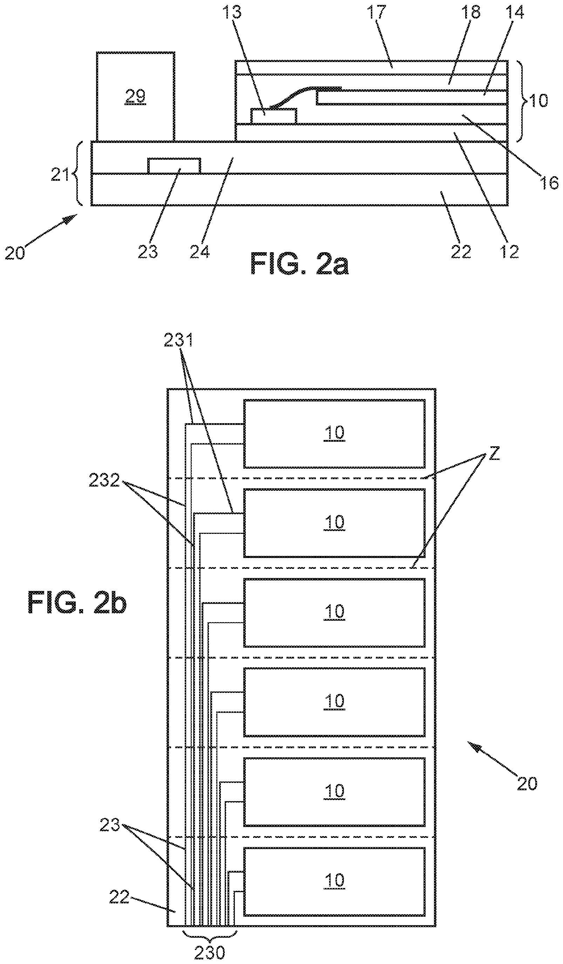

   [Fig. 2a] représente schématiquement une vue en coupe d'un module rapporté sur un support flexible selon un mode de réalisation.
**Fig. 2b**
   [Fig. 2b] représente schématiquement une vue de dessus de modules rapportés sur un support flexible selon un mode de réalisation
**Fig. 3**

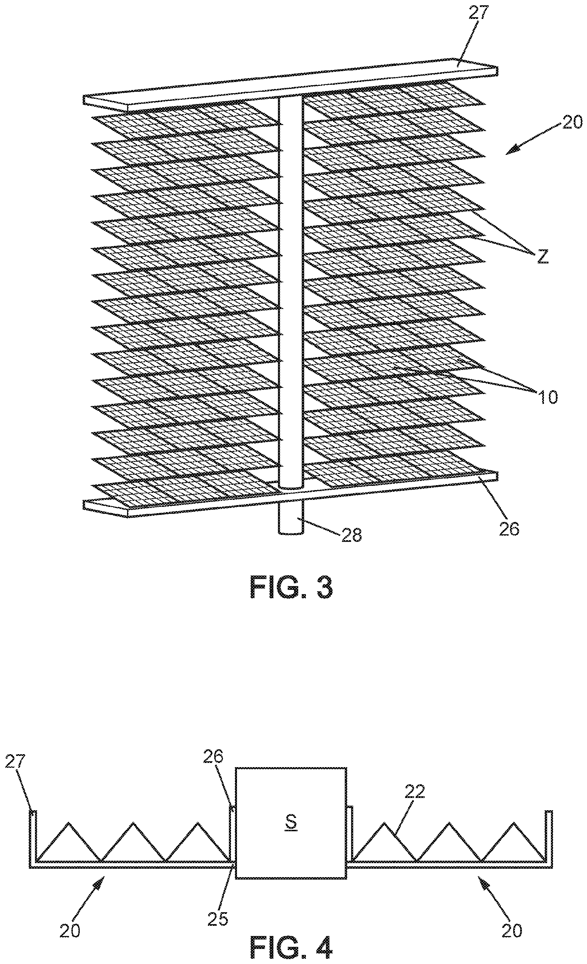

   [Fig. 3] représente schématiquement un générateur solaire selon un mode de réalisation
**Fig. 4**
   [Fig. 4] représente schématiquement un satellite comprenant deux générateurs solaires.
**Fig. 5**

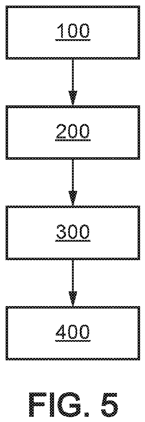

   [Fig. 5] représente schématiquement les principales étapes d'un procédé de fabrication d'un module selon un mode de réalisation.

### Description des modes de réalisation

### Module photovoltaïque

En référence à [Fig. 1a] et [Fig. 1b], on va maintenant décrire un module 10 photovoltaïque pour générateur solaire de satellite. La [Fig. 1a] représente une vue en coupe d'un module, tandis que la [Fig. 1b] représente une vue de dessus d'un module.

Le module 10 comprend un circuit imprimé 11 (également appelé sous l'acronyme anglais PCB pour « printed circuit board »), comprenant au moins un support 12 réalisé en un matériau électriquement isolant, et des pistes électriquement conductrices 13 agencées sur au moins une face du support.

Dans un mode de réalisation, le support 12 est rigide. Il peut par exemple être réalisé en nid d'abeille rigide. Selon une variante plus avantageuse, le support 12 est flexible, et peut être formé d'un film de polyimide, par exemple commercialisé sous le nom commercial Kapton, ou de PEEK.

Dans un mode de réalisation, le circuit imprimé 11 peut être multicouches, c'est-à-dire que le support 12 comprend plusieurs couches de matériau isolant superposées, et des pistes conductrices supplémentaires agencées entre deux couches successives de matériau isolant. Les pistes électriquement conductrices sont quant à elles typiquement réalisées en métal, par exemple en cuivre et peuvent avoir dans certains cas un traitement, en argent par exemple.

Le module 10 comprend en outre au moins deux chaînes 14 de cellules photovoltaïques 15 rapportées sur la face du circuit imprimé 10 sur laquelle sont agencées les pistes conductrices. Les chaînes 14 de cellules sont de préférence collées sur le circuit imprimé 10 au moyen d'une couche 16 de matériau adhésif, par exemple un matériau adhésif à base de silicone ou d'acrylique.

Comme représenté schématiquement sur la [Fig. 1b], dans un module toutes les chaînes 14 de cellules photovoltaïques sont disposées de préférence parallèlement les unes aux autres.

Chaque chaîne 14 comprend une pluralité de cellules 15 photovoltaïques connectées en série les unes aux autres. Selon un exemple non limitatif, les cellules 15 d'une chaîne de cellules sont des cellules à triple jonction InGaP/GaAs/InGaAs, ce type de cellule présentant l'avantage d'un coût réduit, d'une bonne efficacité de conversion photovoltaïque et d'un bon ratio puissance/masse.

De plus, chaque chaîne 14 de cellules photovoltaïques est connectée aux pistes conductrices 13 agencées sur la face du circuit imprimé 10, de sorte que les pistes conductrices établissent une connexion électrique entre les chaînes de cellules. La connexion électrique entre les chaînes est de préférence une connexion série. En variante, cette connexion peut être parallèle. Selon encore une autre variante, dans le cas où le circuit imprimé est de type multicouches comprenant des pistes conductrices supplémentaires disposées entre deux couches de matériau électriquement isolant, les deux types de connexion peuvent être assurées entre les cellules, en fonction des performances attendues pour le module et plus généralement pour le générateur solaire comprenant ce module. Dans encore une variante, les pistes conductrices 13 sont adaptées pour reliées en série les chaînes 14 de cellules du module, et le module peut comprendre en face arrière, c'est-à-dire sur la face du support 12 isolant opposé aux pistes conductrices 13 et aux chaines 14 de cellules, des pistes conductrices additionnelles permettant une connexion parallèle de chaines de cellules.

La connexion électrique entre une cellule d'une chaîne de cellules et une piste conductrice du circuit imprimé est avantageusement réalisée au moyen d'une patte de connexion qui est soudée d'une part à un connecteur de la cellule et d'autre part à la piste conductrice, par exemple par soudure électrique ou ultrasonore.

Enfin, le module 10 comprend une couche de protection 17, adaptée pour protéger les cellules 15, les pistes conductrices 13, et les connexions électriques entre celles-ci, contre les rayonnements, l'oxygène atomique ou les ions présents dans l'espace (par exemple générés par la production électrique du module), et encore contre les décharges électrostatiques. La couche de protection 17 est cependant transparente dans une gamme de longueurs d'onde correspondant à une gamme de conversion photovoltaïque des cellules, pour ne pas diminuer les performances de production électrique du module.

La couche de protection 17 peut être un panneau ou un film unique recouvrant la totalité des chaînes 14 de cellules photovoltaïques, ainsi que les pistes conductrices 13 et les connexions entre les pistes et les cellules. Dans un mode de réalisation particulier, la couche de protection 17 peut recouvrir la totalité de la surface du module.

La couche de protection est avantageusement réalisée en verre transparent.

L'utilisation d'une couche de protection unique et commune à l'ensemble des cellules permet d'utiliser des cellules 15 dépourvues de verre de protection individuel, ce qui rend les cellules moins lourdes et moins coûteuses. La couche de protection 17 est avantageusement collée sur le circuit imprimé et les chaînes de cellules, par une couche 18 de matériau adhésif supplémentaire, puis l'ensemble est laminé comme décrit plus en détails ci-après pour cuire l'adhésif et solidariser l'ensemble du module.

En référence à [Fig. 5], on a représenté schématiquement les principales étapes d'un procédé de fabrication du module décrit précédemment.

Le procédé comprend une première étape 100 de collage des chaînes 14 de cellules photovoltaïques sur la même face du circuit imprimé que celle sur laquelle les pistes conductrices 13 sont réalisées. Ce collage est fait au moyen de la première couche 16 de matériau adhésif.

Les chaînes 14 de cellules sont ensuite connectées lors d'une étape 200 aux pistes conductrices 13 du circuit imprimé, par exemple en rapportant des pattes de connexion et en soudant ces pattes d'une part à une piste conductrice 13, et d'autre part à un connecteur d'une cellule d'extrémité d'une chaîne, par soudure électrique ou ultrasonore.

Le procédé comprend ensuite une étape 300 de collage de la couche de protection 17 sur le circuit imprimé portant les chaînes de cellules, au moyen de la deuxième couche 18 de matériau adhésif. La couche de protection 17 est alors positionnée de manière à recouvrir toutes les cellules, les pistes conductrices et les connexions entre les pistes et les cellules.

Enfin le procédé comprend une étape 400 de laminage de l'ensemble, lors de laquelle le module est placé sous vide et à haute température (environ 80°C) afin de fixer l'ensemble des composants du module. La présence d'une couche de protection commune 17 pour tout le module rend cette étape de mise en oeuvre plus simple que si les cellules comportaient une couche de protection individuelle Cela permet de réduire le temps d'intégration des modules.

### Générateur solaire flexible

En référence aux [Fig. 2a] et [Fig. 2b], on va maintenant décrire un générateur solaire flexible 20 de satellite, comprenant au moins un module 10 selon la description qui précède. Le générateur solaire est adapté pour générer une puissance comprise entre 1 et 18 kW en fonction de l'application envisagée pour le satellite et de son orbite, avec un rapport puissance / poids de plus de 200W/kg.

Le générateur solaire 20 comprend un support flexible électriquement isolant 22, qui est par exemple un film de polyimide ou de PEEK. Dans un mode de réalisation préféré, le générateur solaire comprend un circuit imprimé 21 flexible, comprenant le support flexible 22, et des pistes conductrices 23 réalisées sur une face du support flexible 22, ou dans le support flexible 22. Dans ce dernier cas, le support flexible comprend au moins deux couches de matériau électriquement isolant et les pistes conductrices sont réalisées entre les couches.

Le générateur solaire 20 comprend en outre au moins deux modules 10 selon la description qui précède, rapportés sur le support flexible 22. Avantageusement, les modules 10 sont collés sur le support flexible 22 par une couche d'adhésif 24, l'adhésif choisi étant de préférence un adhésif à base de silicone ou d'époxy. Selon la disposition des pistes conductrices sur ou dans le support flexible 22, le ou les modules peuvent occuper tout ou partie de la surface du support flexible 22.

Le support flexible 22 du générateur solaire 20 permet de réaliser la liaison mécanique entre les modules. De plus, les pistes conductrices 23 peuvent être agencées pour connecter les différents modules en parallèle au satellite, et/ou pour connecter entre eux au moins deux modules en série. Avantageusement, les pistes conductrices 23 comprennent au moins des premières pistes conductrices permettant une connexion d'un ou plusieurs modules au satellite, et dans certains cas elles peuvent également comprendre des deuxièmes pistes conductrices permettant une connexion en série de plusieurs modules entre eux.

Le générateur solaire 20 comprend enfin un dispositif de connexion 25, adapté pour établir une connexion entre les modules 10 d'une part, et/ou pour connecter les modules au satellite d'autre part.

Dans un mode de réalisation, le dispositif de connexion 25 peut être un harnais filaire qui vient se raccorder au satellite d'une part, et à un ou plusieurs module(s) d'autre part.

Dans un mode de réalisation plus avantageux, le générateur solaire 20 comprenant un circuit imprimé 21 comprenant des pistes électriquement conductrices 23, le dispositif de connexion 25 est avantageusement un circuit électrique adapté pour regrouper les pistes électriquement conductrices et les connecter en parallèle. Dans ce cas, et comme représenté par exemple sur la [Fig. 2b], des pistes électriquement conductrices du circuit imprimé peuvent être agencées d'un même côté du support flexible, chaque piste conductrice 23 comprenant une première extrémité 230 adaptée pour être raccordée au dispositif de connexion 25 pour être ensuite connectée au satellite, une deuxième extrémité 231 connectée à une chaîne de cellules d'un module, et une portion intermédiaire 232 rectiligne s'étendant entre les extrémités, l'ensemble des portions intermédiaires 232 des pistes s'étendant parallèlement suivant la dimension principale du générateur solaire, le long dudit côté du support flexible 22, et d'un même côté des modules 10 rapportés sur le support flexible.

De préférence, le dispositif de connexion 25 comprend également une diode de blocage associée respectivement à chaque module, c'est-à-dire, dans l'exemple qui précède, associée à chaque piste électriquement conductrice du circuit imprimé 21.

En référence à la [Fig. 3], dans un mode de réalisation préféré, le support flexible 22, et le cas échéant, l'ensemble du circuit imprimé 21, est pliable selon une pluralité de lignes de pliure Z, de préférence parallèles entre elles, et de préférence séparées d'une distance constante. Les modules 10 sont rapportés sur le support flexible 22 entre deux lignes de pliure Z. Le générateur solaire 20 présente alors de préférence une dimension principale selon une direction perpendiculaire aux lignes de pliure.

Ceci permet, que les modules soient rigides ou non, d'obtenir un générateur solaire flexible qui peut prendre une configuration repliée selon chaque ligne de pliure, pour le lancement du satellite sur lequel le générateur 20 est monté, et une configuration déployée lorsque le satellite est en orbite, afin de pouvoir alimenter le satellite en électricité.

Dans l'exemple représenté sur cette figure, le support flexible peut comprendre des pistes conductrices pour la connexion en série des modules disposés entre deux mêmes lignes de pliure du support flexible, et d'autres pistes conductrices pour la connexion en parallèle au satellite de chaque groupe de modules disposés entre deux mêmes lignes de pliure du support flexible.

Dans le mode de réalisation décrit ci-avant en référence à la figure 2b, où le générateur solaire comprend un circuit imprimé dont les pistes présentent des portions intermédiaires s'étendant parallèlement entre elles le long d'un côté du support flexible, les modules sont avantageusement positionnés sur le support flexible 22 de sorte que chaque chaîne de cellules photovoltaïques s'étende parallèlement aux lignes de pliure, les lignes de pliures étant elles-mêmes perpendiculaires aux portions intermédiaires parallèles des pistes conductrices.

En référence à [Fig. 4], afin de permettre le déploiement du générateur solaire, et son maintien en configuration déployée, celui-ci comprend avantageusement un support rigide sous la forme d'une première 26 et une deuxième 27 plaques de déploiement, reliées respectivement aux extrémités opposées du support flexible, lesdites extrémités étant les extrémités entre lesquelles le support flexible s'étend selon sa dimension principale.

De plus le générateur solaire comprend un organe de déploiement 28 relié aux deux plaques de déploiement 26, 27, permettant de sélectivement écarter ou rapprocher les plaques de déploiement. L'organe de déploiement peut par exemple être un mât télescopique, comme représenté schématiquement sur la [Fig. 4].

Dans ce mode de réalisation, le dispositif de connexion 25 au satellite est avantageusement intégré dans la plaque de déploiement 26 située à l'extrémité du générateur solaire la plus proche du module, cette plaque de déploiement 26 étant avantageusement montée solidairement sur une paroi du satellite.

Dans cet exemple la configuration repliée du générateur solaire est donc une configuration dans laquelle les deux plaques 26, 27 sont rapprochées l'une de l'autre, le support flexible portant les modules étant replié entre les plaques, et la configuration déployée est une configuration dans laquelle les deux plaques 26, 27 sont distantes l'une de l'autre, et le support flexible portant les modules s'étend de façon sensiblement plane entre les plaques.

En référence à la [Fig.4] on a représenté un satellite S comprenant deux générateurs solaires 20 selon la description qui précède, chaque générateur solaire présentant une configuration intermédiaire entre la configuration repliée et la configuration déployée. On comprend que la configuration déployée est obtenue en écartant davantage les plaques 27 du corps principal du satellite.

De retour à [Fig. 2a], le générateur solaire 20 comprend avantageusement des cales 29, qui sont rapportées sur le support flexible 22 de façon adjacente aux modules 10, et qui présentent une hauteur mesurée par rapport au support flexible 22 supérieure à la hauteur d'un module. Ces cales permettent de définir la distance minimale entre deux portions successives du support flexible 22 une fois replié, et permettent donc de protéger les modules contre une pression excessive appliquée lors du pliage du support. Avantageusement, les cales 29 sont réalisées en plots de Kapton ou de fibre de verre/époxy.

Cependant la configuration représentée sur les [Fig. 3] et [Fig. 4] n'est pas limitative et on peut envisager que le générateur flexible soit pliable selon d'autres configurations, ou qu'il soit enroulable plutôt que pliable. Dans ce dernier cas, il ne présente pas de lignes de pliure, le circuit imprimé utilisé pour les modules doit également être flexible, et l'épaisseur de la couche de protection des modules doit être réduite pour conférer la souplesse nécessaire à cette couche de protection.

## Revendications

1. Générateur solaire (20) de satellite, comprenant :
- un circuit imprimé (21) comprenant un support flexible (22) électriquement isolant et une pluralité de pistes électriquement conductrices (23) agencées sur ladite face du support flexible ou dans le support flexible,
- au moins deux modules photovoltaïques (10), rapportés sur une face du support flexible (22), et
- un dispositif de connexion (25) adapté pour établir une connexion entre au moins certains des modules d'une part et/ou pour connecter les modules au satellite d'autre part,
dans lequel chaque module photovoltaïque comprend :
- un circuit imprimé (11) comprenant au moins un support (12) réalisé en un matériau électriquement isolant et des pistes électriquement conductrices (13) agencées sur au moins une face du support (12),
- au moins deux chaînes (14) de cellules photovoltaïques (15), chaque chaîne (14) comprenant une pluralité de cellules photovoltaïques (15) connectées en série, les chaînes de cellules photovoltaïque étant montées sur la face du support (12) portant les pistes électriquement conductrices et connectées auxdites pistes de sorte que lesdites pistes établissent une connexion électrique entre les chaînes de cellules
- une couche de protection (17) optiquement transparente dans une gamme de longueurs d'onde correspondant à une gamme de conversion photovoltaïque des cellules, la couche étant rapportée sur le circuit imprimé (11) de manière à recouvrir au moins la totalité des cellules photovoltaïques (15) et la totalité des pistes (13) électriquement conductrices du circuit imprimé.

2. Générateur solaire (20) selon la revendication 1, dans lequel le support (12) électriquement isolant de chaque module (10) est flexible.

3. Générateur solaire (20) selon l'une des revendications 1 ou 2, dans lequel chaque module comprend en outre une couche de matériau adhésif (16) s'étendant entre les cellules photovoltaïques et le support (12), et une couche de matériau adhésif (18) s'étendant entre la couche de protection et les cellules photovoltaïques.

4. Générateur solaire (20) selon l'une des revendications précédentes, dans lequel les pistes électriquement conductrices (13) sont configurées pour établir une connexion série entre les chaînes de cellules.

5. Générateur solaire (20) selon l'une des revendications précédentes, dans lequel le support flexible (22) électriquement isolant est pliable selon une pluralité de lignes de pliure (Z) parallèles, chaque module (10) étant rapporté sur le support flexible entre deux lignes de pliure (Z).

6. Générateur solaire (20) selon la revendication 5, dans lequel chaque module (10) est rapporté sur le support flexible (22) de sorte que chaque chaine (14) de cellules photovoltaïques s'étende parallèlement aux lignes de pliure.

7. Générateur solaire (20) selon la revendication 5 ou 6, dans lequel le support flexible (22) présente entre deux extrémités opposées une dimension principale s'étendant selon une direction orthogonale aux lignes de pliures (Z),
le générateur solaire (20) comprend en outre une première (26) et une deuxième (27) plaques de déploiement respectivement reliées aux extrémités opposées du support flexible (22), et un organe de déploiement (28) adapté pour sélectivement rapprocher ou écarter les deux plaques de déploiement,
le générateur solaire (20) étant adapté pour prendre une configuration repliée dans laquelle le support flexible (22) est plié selon les lignes de pliure (Z) entre les deux plaques de déploiement, et une configuration déployée dans laquelle le support flexible (22) s'étend de façon sensiblement plane entre les deux plaques de déploiement, lesdites plaques étant écartées l'une de l'autre,
et le dispositif de connexion est intégrée à l'une des plaques de déploiement.

8. Générateur solaire (20) selon l'une des revendications précédentes, dans lequel au moins deux des pistes électriquement conductrices (23) comprennent une première extrémité (230) adaptée pour être raccordée au dispositif de connexion, une deuxième extrémité (231) connectée à une chaîne de cellules, et une portion intermédiaire (232) s'étendant entre les extrémités, l'ensemble des portions intermédiaires des pistes s'étendant parallèlement suivant la dimension principale du générateur solaire.

9. Générateur solaire selon l'une des revendications précédentes, comprenant en outre une cale (29) rapportée sur le support flexible (22) de manière adjacente à chaque module photovoltaïque, la cale (29) s'étendant en saillie par rapport au support flexible à une hauteur par rapport audit support flexibles supérieure à la hauteur d'un module photovoltaïque.

10. Satellite (S), comprenant au moins un générateur solaire selon l'une des revendications précédentes.

11. Procédé de fabrication d'un générateur solaire (20) selon l'une des revendications 1 à 9, comprenant :
la fabrication d'au moins deux modules, ladite fabrication comprenant les étapes suivantes :
- coller (100) au moins deux chaines (14) de cellules photovoltaïques (15), chaque chaîne comprenant une pluralité de cellules photovoltaïques connectées en série, sur un circuit imprimé (11) comprenant un support (12) réalisé en matériau électriquement isolant et des pistes électriquement conductrices (13) agencées sur une face du support, au moyen d'une première couche de matériau adhésif (16),
- connecter (200) les chaînes (14) de cellules photovoltaïques aux pistes électriquement conductrices (13),
- coller (300) une couche de protection (17) optiquement transparente dans une gamme de longueurs d'onde correspondant à une gamme de conversion photovoltaïque des cellules, sur le circuit imprimé et les cellules, de manière qu'elle recouvre l'ensemble des cellules et des pistes conductrices du circuit imprimé, au moyen d'une deuxième couche de matériau adhésif (18), et
- laminer sous vide (400) ensemble le circuit imprimé, les chaînes (14) de cellules photovoltaïques et la couche de protection (17), et
le fait de rapporter chaque module sur une face d'un support flexible (22) électriquement isolant d'un circuit imprimé (21) comprenant ledit support flexible (22) et des pistes électriquement conductrices (23).

12. Procédé selon la revendication précédente, dans lequel l'étape de connexion est mise en oeuvre par soudure électrique ou ultrasonore.

## Patentansprüche

1. Satellitensolargenerator (20) umfassend:
- ein gedruckter Schaltkreis (21), die einen elektrisch isolierenden flexiblen Träger (22) und eine Mehrzahl von elektrischen Leiterbahnen (23), die auf der Fläche des flexiblen Trägers oder im flexiblen Träger angeordnet sind, umfasst,
- mindestens zwei Photovoltaikmodule (10), die auf eine Fläche des flexiblen Trägers (22) aufgesetzt sind, und
- eine Verbindungsvorrichtung (25), die geeignet ist, einerseits eine Verbindung zwischen wenigstens einigen der Module herzustellen und/oder andererseits die Module mit dem Satelliten zu verbinden,
wobei jedes Photovoltaikmodul Folgendes umfasst:
- einen gedruckten Schaltkreis (11), der mindestens einen Träger (12), der aus einem elektrisch isolierenden Material hergestellt ist, und elektrische Leiterbahnen (13), die auf wenigstens einer Fläche des Trägers (12) angeordnet sind, umfasst,
- mindestens zwei Ketten (14) aus Photovoltaikzellen (15), wobei jede Kette (14) eine Mehrzahl von Photovoltaikzellen (15) umfasst, die in Reihe geschaltet sind, wobei die Ketten aus Photovoltaikzellen auf der Fläche des Trägers (12) angebracht sind, die die elektrischen Leiterbahnen trägt, und so mit den Bahnen verbunden sind, dass die Bahnen eine elektrische Verbindung zwischen den Ketten aus Zellen herstellen
- eine Schutzschicht (17), die in einem Wellenlängenbereich optisch transparent ist, der einem photovoltaischen Umwandlungsbereich der Zellen entspricht, wobei die Schicht so auf den gedruckten Schaltkreis (11) aufgebracht ist, dass sie wenigstens alle Photovoltaikzellen (15) und alle elektrischen Leiterbahnen (13) des gedruckten Schaltkreises bedeckt.

2. Solargenerator (20) nach Anspruch 1, wobei der elektrisch isolierende Träger (12) jedes Moduls (10) flexibel ist.

3. Solargenerator (20) nach einem der Ansprüche 1 oder 2, wobei jedes Modul ferner eine Haftmaterialschicht (16), die sich zwischen den Photovoltaikzellen und dem Träger (12) erstreckt, und eine Haftmaterialschicht (18), die sich zwischen der Schutzschicht und den Photovoltaikzellen erstreckt, umfasst.

4. Solargenerator (20) nach einem der vorhergehenden Ansprüche, wobei die elektrischen Leiterbahnen (13) dazu ausgebildet sind, eine serielle Verbindung zwischen den Ketten aus Zellen herzustellen.

5. Solargenerator (20) nach einem der vorhergehenden Ansprüche, wobei der elektrisch isolierende flexible Träger (22) gemäß einer Mehrzahl von parallelen Faltlinien (Z) faltbar ist, wobei jedes Modul (10) zwischen zwei Faltlinien (Z) auf den flexiblen Träger aufgesetzt ist.

6. Solargenerator (20) nach Anspruch 5, wobei jedes Modul (10) so auf den flexiblen Träger (22) aufgesetzt ist, dass sich jede Kette (14) aus Photovoltaikzellen parallel zu den Faltlinien erstreckt.

7. Solargenerator (20) nach Anspruch 5 oder 6, wobei der flexible Träger (22) zwischen zwei gegenüberliegenden Enden eine Hauptabmessung aufweist, die sich in einer Richtung orthogonal zu den Faltlinien (Z) erstreckt,
der Solargenerator (20) ferner eine erste (26) und eine zweite (27) Entfaltungsplatte, die jeweils mit den gegenüberliegenden Enden des flexiblen Trägers (22) verbunden sind, und ein Entfaltungselement (28), das geeignet ist, die zwei Entfaltungsplatten selektiv anzunähern oder zu beabstanden, umfasst,
wobei der Solargenerator (20) geeignet ist, eine zusammengefaltete Ausgestaltung, in welcher der flexible Träger (22) gemäß den Faltlinien (Z) zwischen den zwei Entfaltungsplatten gefaltet ist, und eine entfaltete Ausgestaltung, in welcher sich der flexible Träger (22) im Wesentlichen eben zwischen den zwei Entfaltungsplatten erstreckt, wobei die Platten voneinander beabstandet sind, anzunehmen,
und die Verbindungsvorrichtung in eine der Entfaltungsplatten integriert ist.

8. Solargenerator (20) nach einem der vorhergehenden Ansprüche, wobei wenigstens zwei der elektrischen Leiterbahnen (23) ein erstes Ende (230), das zum Anschluss an die Verbindungsvorrichtung angepasst ist, ein zweites Ende (231), das mit einer Kette aus Zellen verbunden ist, und einen Zwischenabschnitt (232), der sich zwischen den Enden erstreckt, umfassen,
wobei sich die Anordnung der Zwischenabschnitte der Bahnen parallel in der Hauptabmessung des Solargenerators erstreckt.

9. Solargenerator nach einem der vorhergehenden Ansprüche, ferner umfassend einen Keil (29), der angrenzend an jedes Photovoltaikmodul auf den flexiblen Träger (22) aufgesetzt ist, wobei sich der Keil (29) im Verhältnis zum flexiblen Träger auf eine Höhe im Verhältnis zum flexiblen Träger hervorstehend erstreckt, die größer als die Höhe eines Photovoltaikmoduls ist.

10. Satellit (S) umfassend mindestens einen Solargenerator nach einem der vorhergehenden Ansprüche.

11. Verfahren zur Herstellung eines Solargenerators (20) nach einem der Ansprüche 1 bis 9, umfassend:
Herstellen mindestens zweier Module, wobei das Herstellen die folgenden Schritte umfasst:
- Kleben (100) mindestens zweier Ketten (14) aus Photovoltaikzellen (15), wobei jede Kette eine Mehrzahl von Photovoltaikzellen umfasst, die in Reihe geschaltet sind, auf einen gedruckten Schaltkreis (11), der einen Träger (12), der aus elektrisch isolierendem Material hergestellt ist, und elektrische Leiterbahnen (13), die auf einer Fläche des Trägers angeordnet sind, umfasst, mittels einer ersten Haftmaterialschicht (16),
- Verbinden (200) der Ketten (14) aus Photovoltaikzellen mit den elektrischen Leiterbahnen (13),
- Kleben (300) einer Schutzschicht (17), die in einem Wellenlängenbereich optisch transparent ist, der einem photovoltaischen Umwandlungsbereich der Zellen entspricht, auf den gedruckten Schaltkreis und die Zellen, so dass sie die Anordnung der Zellen und elektrischen Leiterbahnen den gedruckten Schaltkreis bedeckt, mittels einer zweiten Haftmaterialschicht (18), und
- Miteinander Vakuumlaminieren (400) des gedruckten Schaltkreises, der Ketten (14) aus Photovoltaikzellen und der Schutzschicht (17), und
Aufsetzen jedes Moduls auf eine Fläche eines elektrisch isolierenden flexiblen Trägers (22) eines gedruckten Schaltkreises (21), der den flexiblen Träger (22) und elektrische Leiterbahnen (23) umfasst.

12. Verfahren nach dem vorhergehenden Anspruch, wobei der Schritt des Verbindens durch Elektro- oder Ultraschallschweißen durchgeführt wird.

## Claims

1. A satellite solar generator (20), comprising:
- a printed circuit board (21) comprising a flexible electrically insulating support (22) and a plurality of electrically conductive tracks (23) arranged on said face of the flexible support or in the flexible support,
- at least two photovoltaic modules (10), attached to one face of the flexible support (22), and
- a connection device (25) adapted for establishing a connection between at least some of the modules on the one hand and/or for connecting the modules to the satellite on the other hand,
wherein each photovoltaic module comprises:
- a printed circuit board (11) comprising at least one support (12) made of an electrically insulating material and electrically conductive tracks (13) arranged on at least one face of the support (12),
- at least two chains (14) of photovoltaic cells (15), each chain (14) comprising a plurality of photovoltaic cells (15) connected in series, the chains of photovoltaic cells being mounted on the face of the support (12) carrying the electrically conductive tracks and connected to said tracks so that said tracks establish an electrical connection between the chains of cells
- a protective layer (17) which is optically transparent in a range of wavelengths corresponding to a range of photovoltaic conversion of the cells, the layer being attached to the printed circuit board (11) so as to cover at least all the photovoltaic cells (15) and all the electrically conductive tracks (13) of the printed circuit board.

2. The solar generator (20) according to claim 1, wherein the electrically insulating support (12) of each module (10) is flexible.

3. The solar generator (20) according to one of claims 1 or 2, wherein each module further comprises a layer of adhesive material (16) extending between the photovoltaic cells and the support (12), and a layer of adhesive material (18) extending between the protective layer and the photovoltaic cells.

4. The solar generator (20) according to one of the preceding claims, wherein the electrically conductive tracks (13) are configured to establish a series connection between the chains of cells.

5. The solar generator (20) according to one of the preceding claims, wherein the flexible electrically insulating support (22) is bendable along a plurality of parallel fold lines (Z), each module (10) being attached to the flexible support between two fold lines (Z).

6. The solar generator (20) according to claim 5, wherein each module (10) is attached to the flexible support (22) so that each chain (14) of photovoltaic cells extends parallel to the fold lines.

7. The solar generator (20) according to claim 5 or 6, wherein the flexible support (22) has between two opposite ends a main dimension extending in a direction orthogonal to the fold lines (Z),
the solar generator (20) further comprises a first (26) and a second (27) deployment plates respectively connected to the opposite ends of the flexible support (22), and a deployment member (28) adapted to selectively move closer or apart the two deployment plates,
the solar generator (20) being adapted to take a folded configuration wherein the flexible support (22) is folded along the fold lines (Z) between the two deployment plates, and a deployed configuration wherein the flexible support (22) extends in a substantially flat manner between the two deployment plates, said plates being spaced apart from one another,
and the connection device is integrated into one of the deployment plates.

8. The solar generator (20) according to one of the preceding claims, wherein at least two of the electrically conductive tracks (23) comprise a first end (230) adapted to be connected to the connection device, a second end (231) connected to a chain of cells, and an intermediate portion (232) extending between the ends, the set of intermediate portions of the tracks extending in parallel along the main dimension of the solar generator.

9. The solar generator according to one of the preceding claims, further comprising a wedge (29) attached to the flexible support (22) adjacent to each photovoltaic module, the wedge (29) projecting relative to the flexible support at a height relative to said flexible support greater than the height of a photovoltaic module.

10. A satellite (S), comprising at least one solar generator according to one of the preceding claims.

11. A method for manufacturing a solar generator (20) according to one of claims 1 to 9, comprising:
the manufacture of at least two modules, said manufacture comprising the following steps:
- bonding (100) at least two chains (14) of photovoltaic cells (15), each chain comprising a plurality of photovoltaic cells connected in series, on a printed circuit board (11) comprising a support (12) made of electrically insulating material and electrically conductive tracks (13) arranged on one face of the support, by means of a first layer of adhesive material (16),
- connecting (200) the chains (14) of photovoltaic cells to the electrically conductive tracks (13),
- bonding (300) an optically transparent protective layer (17) in a range of wavelengths corresponding to a range of photovoltaic conversion of the cells, on the printed circuit board and the cells, so that it covers all the cells and the conductive tracks of the printed circuit board, by means of a second layer of adhesive material (18), and
- vacuum laminating (400) together the printed circuit board, the chains (14) of photovoltaic cells and the protective layer (17), and
the fact of attaching each module on one face of a flexible electrically insulating support (22) of a printed circuit board (21) comprising said flexible support (22) and electrically conductive tracks (23).

12. The method according to the preceding claim, wherein the connection step is carried out by electric or ultrasonic welding.
